(19) Europäisches Patentamt / European Patent Office / Office européen des brevets

(11) **EP 2 874 005 A2**

(12) **DEMANDE DE BREVET EUROPEEN**

(43) Date de publication:
**20.05.2015 Bulletin 2015/21**

(51) Int Cl.:
*G03F 7/00* (2006.01)     *G11B 7/26* (2006.01)
*G03F 7/12* (2006.01)

(21) Numéro de dépôt: **14186497.5**

(22) Date de dépôt: **26.09.2014**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **30.09.2013 FR 1359398**

(71) Demandeur: **Commissariat à l'Énergie Atomique et aux Énergies Alternatives**
**75015 Paris (FR)**

(72) Inventeur: **Martinez, Christophe**
**38100 Grenoble (FR)**

(74) Mandataire: **Brevalex**
**56, Boulevard de l'Embouchure**
**B.P. 27519**
**31075 Toulouse Cedex 2 (FR)**

(54) **Procédé d'inscription d'une image et support associé**

(57) L'invention concerne un procédé d'inscription d'une image source, dans lequel on réalise sous la forme d'une matrice de motifs élémentaires, une reproduction de l'image source.

Le procédé comprend les étapes suivantes :
- dépôt (401) sur un premier substrat (41) d'une première couche opaque (42) ;
- gravure (402) de la première couche opaque (42), de façon à former une matrice de premières cellules (440) présentant chacune un parmi plusieurs premiers motifs prédéterminés ;
- dépôt d'au moins une deuxième couche opaque (45) ; et
- gravure de la deuxième couche opaque (45), de façon à former une matrice de deuxièmes cellules (470) présentant chacune un parmi plusieurs deuxièmes motifs prédéterminés, les motifs élémentaires étant définis par la superposition d'un deuxième motif et d'un premier motif.

L'invention concerne également un support d'image obtenu à l'aide d'un tel procédé.

FIG 4

**Description**

**DOMAINE TECHNIQUE**

La présente invention concerne le domaine de l'inscription par photolithographie d'une image sur un support, et plus particulièrement le domaine des procédés d'archivage d'une image.

L'archivage d'une image désignera ici le stockage d'une reproduction de cette image en vue d'une lecture ultérieure « par transparence ». Il s'agit généralement d'une reproduction en dimensions réduites de cette image, souvent en un seul exemplaire.

Dans tout le texte, le terme « image » désigne toute représentation graphique telle qu'une photographie, un texte, un tableau, un dessin, etc.

L'invention concerne également le domaine des supports d'image réalisés à l'aide de tels procédés.

**ÉTAT DE LA TECHNIQUE ANTÉRIEURE**

On connaît dans l'art antérieur de nombreux procédés d'inscription par photolithographie d'une image sur un support. On présentera ici plus particulièrement le domaine de l'archivage d'une image, bien que l'invention présentée par la suite puisse être étendue au domaine plus large de l'inscription d'une image par photolithographie.

On a l'habitude de stocker les images sous forme numérique, sur des supports de stockage tels que des disques durs d'ordinateur, et des disques optiques numériques enregistrables (CD ROM, DVD, etc.). De tels supports présentent cependant une durée de vie limitée, typiquement de l'ordre d'une dizaine d'années. En outre, les formats de codage peuvent devenir obsolètes et empêcher la récupération de l'image à partir des données numériques stockées.

On connaît dans l'art antérieur différents procédés offrant des solutions d'archivage à long terme pour un encombrement réduit. Ces procédés consistent à réaliser un tramage de l'image, puis à graver par photolithographie sans masque une couche d'un matériau opaque déposé sur un substrat transparent, pour reproduire en dimensions réduites l'image tramée. On obtient ainsi un support d'archivage, dans lequel une image est archivée en format analogique. On trouvera dans le document EP 2 105 921 un exemple d'un tel procédé d'archivage d'image.

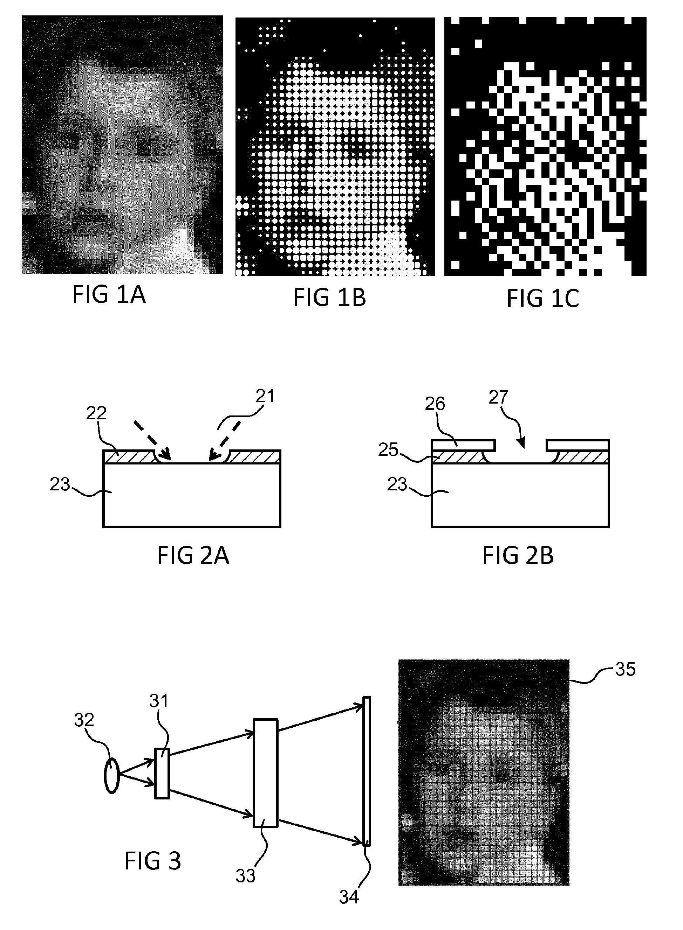

L'étape de tramage consiste à convertir une image en niveaux de gris, en une image en noir et blanc, faite d'une matrice de cellules de mêmes dimensions, dénommées « cellules de tramage ». Le terme « niveau de gris » pourra également désigner des dégradés d'intensité d'une couleur. On connaît par exemple le tramage par modulation de fréquence, dans lequel chaque cellule est homogène : entièrement noire ou entièrement blanche. On connaît également le tramage par modulation d'amplitude dans lequel chaque cellule contient une forme de taille variable inscrite en blanc sur noir ou en noir sur blanc. On a représenté à la figure 1A une image à archiver. La figure 1B représente cette image après un tramage par modulation d'amplitude. La figure 1C représente cette image après un tramage par modulation de fréquence.

La gravure par photolithographie sans masque se fait par écriture directe au laser, sans étape de masquage de zones prédéfinies. La gravure par photolithographie sans masque peut être une gravure directe : le matériau opaque est photosensible et le faisceau laser est appliqué directement sur la couche de matériau opaque. La figure 2A représente une gravure directe par photolithographie sans masque. Le faisceau laser 21 grave une couche 22 de matériau opaque photosensible situé sur un substrat transparent 23. La gravure par photolithographie sans masque peut être une gravure indirecte. Une gravure indirecte par photolithographie sans masque est représentée à la figure 2B. Une couche opaque 25 recouvre un substrat transparent 23. On met alors en oeuvre les étapes suivantes :

- on recouvre la couche opaque 25 d'une couche sacrificielle photosensible 26 telle qu'une résine photosensible ;
- on applique le faisceau laser sur la couche sacrificielle photosensible 26 de façon à transformer le matériau dans les zones insolées ;
- on grave les zones transformées de la couche 26 de manière à rendre accessible la couche 25 au regard des zones 27 découvertes ;
- on grave le matériau opaque 25 en appliquant un composé chimique auquel la couche sacrificielle photosensible 26 restante est insensible et la couche opaque 25 est sensible : de cette façon le composé chimique grave la couche opaque 25 à travers l'ouverture 27 ;
- on élimine la couche sacrificielle photosensible 26.

La lecture du support d'archivage est assurée par un filtre passe bas qui supprime les variations fines de la structure du tramage en dessous de l'échelle de la cellule pour ne garder que les évolutions moyennées à l'échelle de quelques cellules. Le support d'archivage peut par exemple être lu par de simples moyens d'agrandissement optiques. Le support d'archivage 31 est éclairé par une source lumineuse 32. Une optique 33 image le support d'archivage 31 sur un détecteur 34 tel qu'un détecteur matriciel. L'optique 33 présente une fonction de transfert optique qui introduit un flou optique assimilable à une tache gaussienne de largeur (on parle de « waist ») égale à quelques pixels, typiquement deux ou trois. Le grossissement de l'optique 33 est adapté pour faire correspondre la taille d'une cellule de tramage avec la taille du pixel du détecteur matriciel 34. Les teintes sombres codées dans le support d'archivage 31 sont relatives à la couche opaque et les teintes claires aux ouvertures gravées dans la couche opaque et libérant la surface du substrat transparent. On obtient l'image 35 sur le détecteur matriciel 34.

Si l'image est en couleurs, plusieurs reproductions sont archivées, correspondant à la décomposition de l'image en trois composantes par exemple :

- rouge, vert, bleu (décomposition RVB) ; ou
- teinte, saturation, intensité lumineuse (décomposition HSV) ; ou
- intensité lumineuse, première composante chromatique pour les couleurs entre le vert et le rouge, deuxième composante chromatique pour les couleurs entre le bleu et le jaune (décomposition LAB).

Les procédés existants utilisent typiquement en tant que couche opaque une couche d'oxyde de platine $PtO_x$ de 60 nm environ d'épaisseur, où x est notamment un réel compris entre 1 et 2. Une telle couche d'oxyde de platine présente une transmission inférieure à 5%, pour une taille minimum d'ouverture correspondant à un disque de 1,5 $\mu$m de diamètre.

Ces procédés présentent des limitations, dans le cas où l'on souhaite archiver des images en haute définition. Ces images en haute définition sont réalisées par exemple à l'aide des nouvelles générations d'appareil photo numérique.

Par exemple, une image en haute définition est codée sur 8 bits : chaque pixel de l'image peut prendre un niveau de gris parmi 256 ($2^8$) niveaux de gris disponibles. Pour coder autant de niveaux de gris dans le support d'archivage, la solution connue est qu'un pixel de l'image corresponde à un grand nombre de cellules de tramage. Un inconvénient d'une telle solution est alors que l'on augmente la surface de la zone du support d'archivage correspondant à cette image en haute définition.

Un objectif de la présente invention est de proposer un procédé d'inscription d'une image source, qui ne présente pas au moins l'un des inconvénients de l'art antérieur.

En particulier, un objectif de la présente invention est de proposer un procédé d'inscription d'une image source par photolithographie, qui permette une écriture compacte d'images sources.

En particulier, un objectif de la présente invention est de proposer un procédé d'inscription d'une image source par photolithographie, qui permette une écriture compacte d'images sources en haute définition, typiquement une définition d'au moins 8 bits, par exemple 16 bits.

Un autre objectif de la présente invention est de proposer un support d'image obtenu à l'aide d'un tel procédé.

## EXPOSÉ DE L'INVENTION

La présente invention est définie par un procédé d'inscription d'une image source, dans lequel on réalise sous la forme d'une matrice de motifs élémentaires, une reproduction de l'image source, le procédé comprenant les étapes suivantes :

- dépôt sur un premier substrat d'une première couche opaque ;
- gravure de la première couche opaque sur toute son épaisseur, par photolithographie, de façon à former une matrice de premières cellules présentant chacune un parmi plusieurs premiers motifs prédéterminés.

Le procédé selon l'invention comprend en outre les étapes suivantes :

- un dépôt d'au moins une deuxième couche opaque, de façon à ce que la deuxième couche opaque se superpose à la première couche opaque ; et
- une gravure de ladite deuxième couche opaque sur toute son épaisseur, par photolithographie, de façon à former sur la deuxième couche opaque une matrice de deuxièmes cellules présentant chacune un parmi plusieurs deuxièmes motifs prédéterminés, lesdits motifs élémentaires étant chacun définis par la superposition d'un premier motif parmi lesdits premiers motifs prédéterminés et d'un second motif parmi lesdits deuxièmes motifs prédéterminés, et au moins un motif élémentaire étant défini par la superposition d'un premier motif sur un second motif de forme différente.

Dans tout le texte, une couche d'un matériau opaque, ou couche opaque, désigne une couche dont le coefficient de transmission est inférieur à celui du premier substrat. Ce coefficient de transmission peut être nul, du moment qu'il permet la formation du motif élémentaire obtenu par les couches superposées. Le coefficient de transmission est défini pour les longueurs d'onde du visible, de préférence entre 400 nm et 800 nm.

De préférence, le procédé d'inscription selon l'invention réalise un archivage d'une image source dans un support d'archivage comprenant un premier substrat transparent et un second substrat transparent. Selon un tel procédé :

- le dépôt de la première couche opaque est réalisé sur le premier substrat transparent ;
- les étapes de gravure sont réalisées par photolithographie sans masque ; et
- le dépôt d'une deuxième couche opaque est réalisé de façon à ce que la deuxième couche opaque se trouve entre la première couche opaque et le deuxième substrat transparent.

Les première et seconde couches opaques présentent de préférence des degrés d'opacité respectifs différents l'un de l'autre. Le degré d'opacité désigne le taux ou coefficient d'extinction, c'est-à-dire l'inverse du taux ou coefficient de transmission. Le degré d'opacité est défini de préférence pour les longueurs d'onde du visible, de préférence entre 400 nm et 800 nm.

Les première et seconde couches opaques présentent de préférence des épaisseurs différentes et sont formées par un même matériau. On réalise ainsi des première et seconde couches opaques présentant des degrés d'opacité respectifs différents l'un de l'autre.

En variante, les première et seconde couches opaques peuvent consister chacune en un matériau différent. Ces matériaux présentent avantageusement des propriétés différentes de transmission de la lumière. On peut ainsi réaliser des première et seconde couches opaques présentant une même épaisseur, et avec des degrés d'opacité respectifs différents l'un de l'autre.

Le procédé selon l'invention peut comprendre une étape initiale de codage de l'image source, selon un tramage à modulation de fréquence ou un tramage à modulation d'amplitude, le tramage mettant en oeuvre des motifs élémentaires selon l'invention. Selon un mode de réalisation avantageux :

- chaque première cellule et deuxième cellule est soit intégralement gravée, soit non gravée, définissant ainsi par superposition une première série de motifs élémentaires disponibles pour réaliser la reproduction de l'image source ; et
- on réalise un tramage à modulation de fréquence de l'image source, à l'aide de motifs de codage choisis parmi ladite première série de motifs élémentaires.

Selon une variante de ce mode de réalisation :

- chaque première cellule et deuxième cellule est gravée, ou non gravée, ou gravée de façon à former une surface fermée transparente dans une cellule à bords opaques ou une surface fermée opaque dans une cellule à bords transparents, définissant ainsi par superposition une seconde série de motifs élémentaires disponibles pour réaliser la reproduction de l'image source ; et
- on réalise un tramage à modulation d'amplitude de l'image source, à l'aide de motifs de codage choisis parmi ladite seconde série de motifs élémentaires.

Le procédé selon l'invention, lorsqu'il réalise un archivage tel que décrit ci-dessus, peut comprendre les étapes suivantes :

- dépôt de la deuxième couche opaque sur le deuxième substrat transparent ;
- gravure, par photolithographie, de la deuxième couche opaque ;
- collage, sur la première couche opaque, de la deuxième couche opaque déposée sur le deuxième substrat transparent.

En variante, le procédé selon l'invention, lorsqu'il réalise un archivage tel que décrit ci-dessus, peut comprendre les étapes suivantes :

- au moins un cycle comprenant les étapes suivantes :

  - dépôt d'un matériau transparent sur la première couche opaque précédemment gravée ;
  - dépôt de la seconde couche opaque sur le matériau transparent ;
  - gravure, par photolithographie, de la nouvelle couche opaque ;

- collage du deuxième substrat transparent sur la seconde couche opaque précédemment gravée.

En variante, le procédé selon l'invention, lorsqu'il réalise un archivage tel que décrit ci-dessus, peut comprendre les étapes suivantes :

- au moins un cycle comprenant les étapes suivantes :

  - collage, sur la première couche opaque précédemment gravée, d'un substrat transparent intermédiaire ;
  - gravure, par photolithographie, de la seconde couche opaque déposée sur le substrat transparent intermédiaire ;

- collage du deuxième substrat sur la seconde couche opaque précédemment gravée.

En variante, le procédé selon l'invention, lorsqu'il réalise un archivage tel que décrit ci-dessus, peut comprendre les étapes suivantes :

- au moins un cycle comprenant des étapes suivantes :

  - dépôt, sur la première couche opaque précédemment gravée, de la seconde couche opaque ;
  - gravure, par photolithographie, de la seconde couche opaque ;

- collage du deuxième substrat transparent sur la seconde couche opaque précédemment gravée.

Ainsi, dans chacune de ces variantes, le dépôt de la deuxième couche opaque est réalisé après la gravure de la première couche opaque.
La gravure de la deuxième couche opaque peut être réalisée avant ou après dépôt de la deuxième couche opaque sur la première couche opaque gravée.
Le procédé selon l'invention, lorsqu'il réalise un archivage tel que décrit ci-dessus, peut comprendre les étapes suivantes :

- décomposition selon trois composantes d'une image à archiver;
- inscription desdites trois composantes, chacune dans une zone d'archivage du support d'archivage et entre le premier substrat transparent et le deuxième substrat transparent, au moins une desdites composantes étant inscrite dans une zone d'archivage, dite zone d'archivage haute définition à l'aide d'un procédé réalisant un archivage tel que décrit ci-dessus, et au moins une desdites composantes étant inscrite dans une zone d'archivage, dite zone d'archivage basse définition, et en gravant, par photolithographie une unique couche opaque.

De préférence, on décompose une image à archiver selon une décomposition HSV pour obtenir une composante « teinte », une composante « saturation », et une composante « intensité lumineuse », on inscrit les composantes « teinte » et « saturation » dans la zone d'archivage haute définition, et on inscrit la composante « intensité lumineuse » dans la zone d'archivage basse définition.
Le procédé selon l'invention comprend avantageusement une étape de lecture en transparence (ou autrement dit lecture en transmission) de la reproduction d'une image source, comprenant les étapes suivantes :

- éclairage de ladite reproduction à l'aide d'une source lumineuse située d'un côté de ladite reproduction ;
- détection d'une image de ladite reproduction, à l'aide d'un détecteur situé du côté de ladite reproduction opposé à la source lumineuse.

L'invention concerne également un support d'image dans lequel est stockée, sous la forme d'une juxtaposition de motifs élémentaires, une reproduction d'une image source, ledit support d'image comprenant, sur un premier substrat, une première couche opaque gravée sur toute son épaisseur par photolithographie et formant une matrice de premières cellules présentant chacune un parmi plusieurs premiers motifs prédéterminés. Le support selon l'invention présente les caractéristiques suivantes :

- le support d'image comprend au moins une deuxième couche opaque gravée sur toute son épaisseur par photolithographie, formant une matrice de deuxièmes cellules, chaque deuxième cellule présentant un parmi plusieurs deuxièmes motifs prédéterminés ; et
- la deuxième couche opaque est située sur la première couche opaque de façon à définir lesdits motifs élémentaires, formés par la superposition d'un premier motif et un deuxième motif, et au moins un motif élémentaire étant défini par la superposition d'un premier motif sur un second motif de forme différente.

Le support d'image selon l'invention peut former un support d'archivage de l'image source et :

- comprendre au moins une zone d'archivage dite haute définition dans laquelle est stockée la reproduction de l'image source ;
- comprendre un premier substrat transparent et un second substrat transparent, la première couche opaque étant située sur le premier substrat transparent et la deuxième couche opaque étant située entre la première couche opaque et le deuxième substrat transparent.

La première couche opaque et la deuxième couche opaque peuvent présenter des épaisseurs différentes, chaque épaisseur étant comprise entre 10 nm et 200 nm.

Chaque première cellule et deuxième cellule peut être soit intégralement gravée, soit non gravée.

En variante, chaque première cellule et deuxième cellule peut être intégralement gravée, ou non gravée, ou gravée de façon à former une surface fermée transparente dans une cellule à bords opaques ou une surface fermée opaque dans une cellule à bords transparents, des surfaces fermées formées dans différentes premières cellules présentant des dimensions différentes, des surfaces fermées formées dans différentes deuxièmes cellules présentant des dimensions différentes.

Dans un mode de réalisation préféré, le support d'image est un support d'archivage et il comprend :

- une première zone d'archivage haute définition, dans laquelle est stockée une reproduction d'une première image source correspondant à une première parmi trois composantes d'une image à archiver;
- une première zone d'archivage basse définition, dans laquelle est stockée une reproduction d'une deuxième image source correspondant à la deuxième composante de l'image à archiver, la zone d'archivage basse définition comprenant, entre le premier substrat transparent et le second substrat transparent, une unique couche opaque gravée par photolithographie ; et
- une deuxième zone d'archivage haute définition ou une deuxième zone d'archivage basse définition, dans laquelle est stockée une reproduction d'une troisième image source correspondant à la troisième composante de l'image à archiver.

L'invention concerne également un système comprenant un support d'image selon l'invention et des moyens de lecture en transparence (ou autrement dit lecture en transmission) de la reproduction d'une image source située dans ce support d'image.

Les moyens de lecture en transparence comprennent une source lumineuse située d'un côté dudit support d'image, et un détecteur situé du côté du support d'image opposé à la source lumineuse.

## BRÈVE DESCRIPTION DES DESSINS

La présente invention sera mieux comprise à la lecture de la description d'exemples de réalisation donnés à titre purement indicatif et nullement limitatif, en faisant référence aux dessins annexés parmi lesquels :

- la figure 1A illustre une image à archiver;
- la figure 1B illustre l'image de la figure 1A, après un tramage par modulation d'amplitude ;
- la figure 1C illustre l'image de la figure 1A, après un tramage par modulation de fréquence ;
- la figure 2A illustre une gravure directe par photolithographie sans masque ;
- la figure 2B illustre une gravure indirecte par photolithographie sans masque ;
- la figure 3 illustre une installation de lecture d'un support d'archivage ;
- la figure 4 illustre un mode de réalisation de procédé d'inscription selon l'invention ;
- la figure 5A illustre une vue de profil d'une représentation schématique d'un support d'image selon l'invention ;
- la figure 5B illustre une vue de face d'une représentation schématique d'un support d'image selon l'invention ;
- la figure 6A illustre un premier exemple de combinaisons de première et deuxième cellules, formant les motifs élémentaires selon l'invention ;
- la figure 6B illustre un deuxième exemple de combinaisons de première et deuxième cellules, formant les motifs élémentaires selon l'invention ;
- la figure 7A illustre une étape de photolithographie sans masque d'une couche opaque épaisse ;
- la figure 7B illustre une étape de photolithographie sans masque d'une couche opaque mince ;
- la figure 7C illustre une taille minimale d'ouverture dans une cellule en fonction d'une épaisseur de couche opaque correspondant à cette cellule ;
- la figure 8 illustre une ouverture dans une cellule et la décomposition d'une cellule selon une grille correspondant aux déplacements d'un faisceau laser relativement à la cellule ;
- les figures 9A à 9D illustrent différentes étapes de la réalisation d'une bibliothèque de motifs élémentaires adaptée à une dynamique de tramage souhaitée ;

- les figures 10A et 10B illustrent un défaut d'alignement d'un premier motif relativement à un deuxième motif ;
- les figures 11A et 11B illustrent deux variantes d'un premier mode de réalisation de procédé d'inscription selon l'invention ;
- la figure 12 illustre un deuxième mode de réalisation de procédé d'inscription selon l'invention ;
- la figure 13 illustre un troisième mode de réalisation de procédé d'inscription selon l'invention ;
- la figure 14 illustre un quatrième mode de réalisation de procédé d'inscription selon l'invention ;
- la figure 15 illustre un support d'image selon l'invention, comprenant une zone d'archivage haute définition et une zone d'archivage basse définition ; et
- la figure 16 illustre une comparaison de l'erreur quadratique moyenne entre une image source et sa représentation sous forme de motifs élémentaires, dans le cas d'un archivage selon l'art antérieur et dans le cas d'un archivage selon l'invention.

## EXPOSÉ DÉTAILLÉ DE MODES DE RÉALISATION PARTICULIERS

Les figures 1A, 1B, 1C, 2A, 2B, et 3 ont déjà été décrites en introduction.

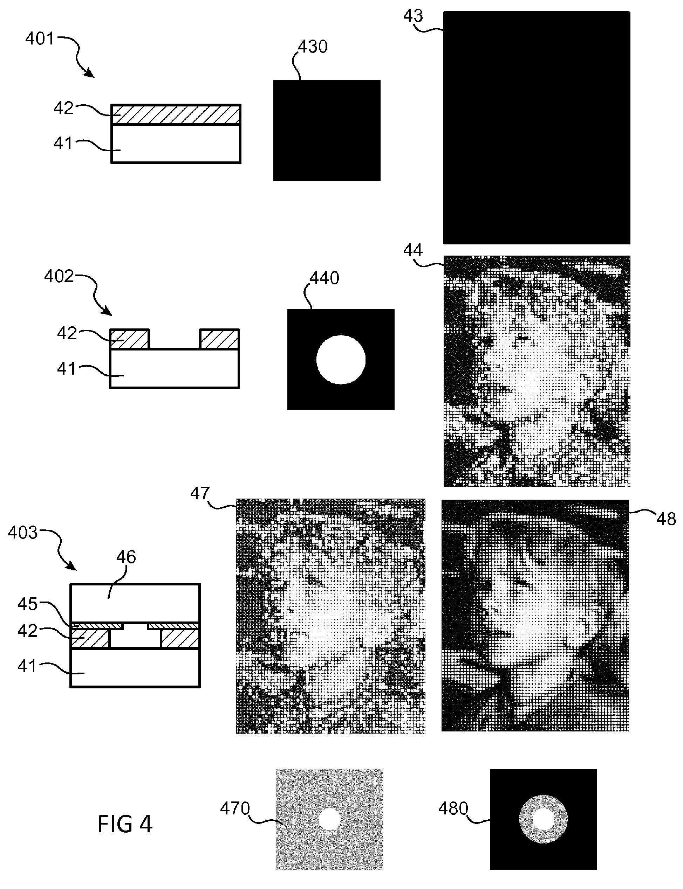

On va tout d'abord décrire, en référence à la figure 4, un procédé d'inscription d'une image source selon l'invention.

On choisit d'illustrer le cas particulier dans lequel le procédé d'inscription selon l'invention forme un procédé d'archivage. Le support d'image réalisé peut alors être nommé « support d'archivage ».

Le procédé d'inscription selon l'invention comprend une première étape 401 de dépôt, sur un premier substrat transparent 41, d'une première couche opaque 42. A ce stade, la première couche opaque 42 forme une matrice 43 de premières cellules 430 toutes identiques et opaques.

Au cours d'une deuxième étape 402, on réalise une gravure de la première couche opaque 42 par photolithographie.

La gravure par photolithographie peut être une gravure sans masque, en particulier dans le contexte de l'archivage d'un unique exemplaire d'une image source.

En variante, la gravure par photolithographie peut être une gravure avec masque. Une gravure avec masque met en oeuvre une gravure d'un ensemble de motifs dans un masque source. L'ensemble de motifs est reproduit sur des substrats, en autant d'exemplaires que souhaité, par projections au travers de ce masque. Cette variante est avantageuse pour une reproduction d'une image en plusieurs exemplaires. Ce sera par exemple le cas pour des applications de marquage de produit en vue d'identifier de façon certaine le fabriquant de ce produit.

On forme ainsi une matrice 44 de premières cellules 440 présentant chacune un parmi plusieurs motifs prédéterminés. La première couche opaque est gravée sur toute son épaisseur.

Dans une troisième étape 403, on dépose au moins une deuxième couche opaque 45, de façon à ce que cette deuxième couche opaque 45 se trouve entre la première couche opaque 42 et un deuxième substrat transparent 46, et on grave cette deuxième couche opaque. On pourra également parler d'une réalisation d'au moins une deuxième couche opaque, de façon à ce que cette deuxième couche opaque 45 se trouve entre la première couche opaque 42 et le deuxième substrat transparent 46. Le deuxième substrat transparent 46 sert de couche de protection pour les couches opaques gravées. Le procédé selon l'invention n'est pas limité à un ordre entre les étapes de dépôt de la deuxième couche opaque 45 et de gravure de celle-ci, comme le montrent les exemples qui suivent. La deuxième couche opaque 45 est également gravée par photolithographie (avec ou sans masque). La deuxième couche opaque est gravée sur toute son épaisseur. Cette gravure forme une matrice 47 de deuxièmes cellules 470 présentant chacune un parmi plusieurs motifs prédéterminés. La superposition de la matrice 44 de premières cellules sur la matrice 47 de deuxièmes cellules forme une matrice 48 de cellules 480 présentant chacune un motif élémentaire formé par la superposition d'un deuxième motif sur un premier motif. Au moins un motif élémentaire est formé par la superposition d'un deuxième motif sur un premier motif, ledit deuxième motif étant différent du premier.

La matrice 48 est une matrice de motifs élémentaires et correspond à une reproduction en dimensions réduites d'une image source, cette image source ayant été tramée.

Ainsi, on voit que l'invention permet d'obtenir, pour une taille de cellule donnée, un nombre plus élevé de motifs élémentaires disponibles pour construire une reproduction en dimensions réduites d'une image source. On pourra ainsi coder tous les niveaux de gris d'une image haute définition à l'aide d'un nombre restreint de cellules. On réalise ainsi un archivage compact d'une image source en haute définition, typiquement une définition d'au moins 8 bits.

On remarque que l'on obtient cet effet sans qu'il soit nécessaire d'avoir recours à des procédés ou des outils de gravure offrant une meilleure précision que dans l'art antérieur. On remarque également que l'on obtient cet effet sans qu'il soit nécessaire d'avoir recours à des procédés ou des outils de gravure permettant de graver des surfaces de plus petite dimension que dans l'art antérieur.

A la figure 4, on a pris l'exemple de deux couches opaques, mais on pourra prévoir plus de deux couches opaques, par exemple 3, 4, 5 ou 6.

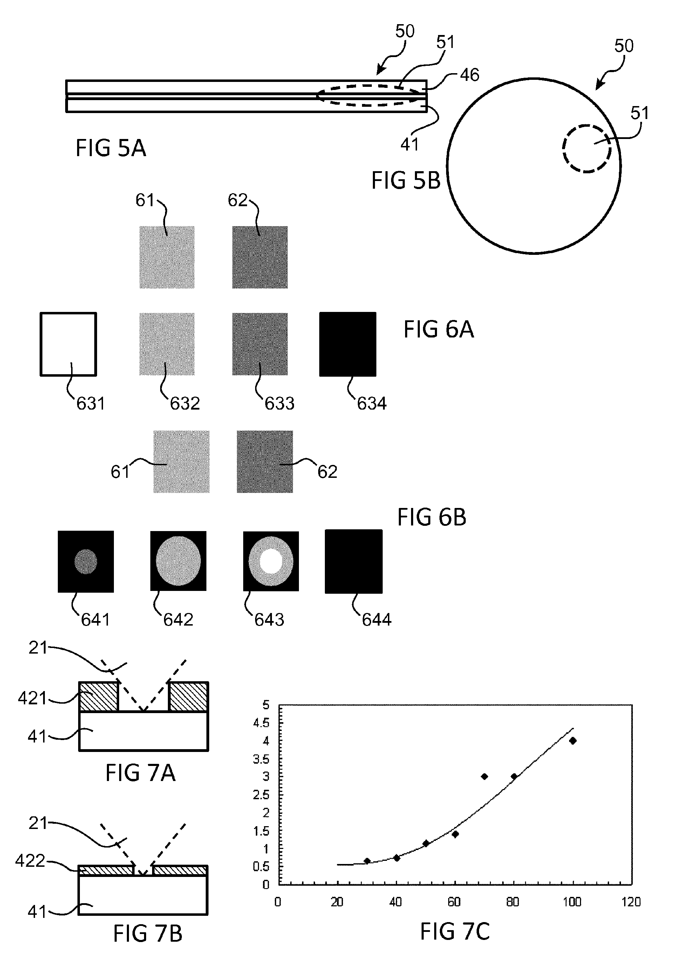

On a pris l'exemple d'une gravure d'une cellule par réalisation d'une ouverture circulaire (ou disque) dans la cellule. Cet exemple n'est pas limitatif, et d'autres exemples seront énumérés en référence aux figures 6A et 6B.

Les gravures mettent en oeuvre des procédés de photolithographie, offrant des résolutions de gravure dans une couche opaque de l'ordre du $\mu$m.

On pourra parler de tramage multi-niveau ou tramage multicouche, pour désigner le procédé selon l'invention.

En variante, le premier substrat n'est pas forcément transparent, et la deuxième couche opaque 46 n'est pas recouverte d'un second substrat transparent. Cette variante correspond à une simple inscription, par photolithographie, d'une image sur un support. Le procédé selon l'invention offre là-encore une excellente définition d'image pour une surface d'inscription réduite. Cette variante se combine avantageusement à la mise en oeuvre de gravures par photolithographie avec masque.

La figure 5A illustre une vue de profil d'un support d'image 50 représenté schématiquement, et obtenu à l'aide d'un procédé d'inscription selon l'invention. Il s'agit plus particulièrement d'un support d'archivage 50, obtenu à l'aide d'un procédé d'archivage tel que décrit en référence à la figure 4. La matrice de motifs élémentaires définie ci-avant est formée dans une zone d'archivage haute définition 51, entre le premier substrat transparent 41 et le deuxième substrat transparent 46. La figure 5B illustre une vue de face du support d'archivage 50 représenté schématiquement.

Le premier substrat transparent et le deuxième substrat transparent consistent par exemple chacun en une couche de quartz ou de saphir. Le premier substrat transparent et le deuxième substrat transparent peuvent également être formés d'une matière plastique souple ou d'une matière plastique rigide telle que celles utilisées pour réaliser les disques optiques. L'épaisseur des premier et deuxième substrats transparents est de l'ordre du mm, par exemple inférieure à 1 mm, en particulier égale à 0,7 mm.

Chaque couche opaque consiste par exemple en une couche métallique telle qu'une couche de chrome, une couche de couche de nitrure de titane, ou une couche d'oxyde de platine $PtO_x$. L'épaisseur d'une couche opaque est généralement inférieure à 200 nm, voire inférieure à 100 nm, par exemple égale à 60 nm, 40 nm ou 30 nm.

La figure 6A illustre un premier exemple de combinaisons de première et deuxième cellules, formant les motifs élémentaires selon l'invention.

On remarque que la première cellule 61 non gravée présente un coefficient de transmission supérieur à celui de la deuxième cellule 62 non gravée. Le coefficient de transmission dépend de l'épaisseur de la couche opaque correspondante. Par exemple, une couche de 40 nm d'épaisseur d'oxyde de platine présente un coefficient de transmission proche de 5%, tandis qu'une couche de 30 nm d'épaisseur d'oxyde de platine présente un coefficient de transmission proche de 10%.

Chaque première cellule 61 est soit entièrement gravée, soit non gravée. Chaque deuxième cellule 62 est soit entièrement gravée, soit non gravée. On obtient ainsi un jeu de quatre motifs élémentaires 631, 632, 633, 634, correspondant respectivement à la superposition :

- d'une deuxième cellule 62 entièrement gravée sur une première cellule 61 entièrement gravée ;
- d'une deuxième cellule 62 entièrement gravée sur une première cellule 61 non gravée ;
- d'une deuxième cellule 62 non gravée sur une première cellule 61 entièrement gravée ; et
- d'une deuxième cellule 62 non gravée sur une première cellule 61 non gravée.

Ces quatre motifs élémentaires 631, 632, 633, 634 définissent quatre motifs de codage disponibles dans le cadre d'un tramage à modulation de fréquence. Le niveau de gris d'un tel motif de codage correspond au coefficient de transmission du motif élémentaire associé.

Un exemple de tramage à modulation de fréquence est le tramage à diffusion d'erreur de type Floyd Steinberg. Il s'agit, pour chaque pixel d'une image, de comparer son niveau de gris aux niveaux de gris de deux motifs de codage (noir ou blanc). L'image est codée en associant à chaque pixel un des motifs de codage. Pour cela, on tient compte :

- du motif de codage dont le niveau de gris est le plus proche de celui du pixel à coder ; et
- de la somme des erreurs liées aux codages précédents, chaque erreur correspondant à la différence (positive ou négative) entre un niveau de gris d'un pixel et le niveau de gris du motif de codage associé.

On adapte facilement ce principe à un nombre N de motifs de codage, N supérieur à 2. Des logiciels connus tels que « Gimp » permettent de réaliser un tramage à diffusion d'erreur de type Floyd Steinberg sur N motifs de codage, N supérieur à 2.

On relèvera qu'on peut subdiviser un pixel de l'image source en plusieurs zones à associer à un motif de codage.

Chaque couche opaque est gravée de façon à réaliser un damier prédéterminé.

La figure 6B illustre un deuxième exemple de combinaisons de première et deuxième cellules, formant les motifs élémentaires selon l'invention. La figure 6B correspond au cas d'un tramage à modulation d'amplitude.

Chaque première cellule 61 est soit entièrement gravée, soit non gravée, soit gravée de façon à dessiner une surface fermée transparente dans une cellule à bords opaques ou une surface fermée opaque dans une cellule à bords transparents.

A la figure 6B, on a pris l'exemple :

- d'une première cellule 61 soit non gravée, soit dans laquelle on a gravé une ouverture circulaire centrée sur la cellule présentant un premier diamètre ; et
- d'une deuxième cellule 62 soit non gravée, soit dans laquelle on a gravé une ouverture circulaire centrée sur la cellule présentant un deuxième diamètre.

On obtient ainsi un jeu de quatre motifs élémentaires 641, 642, 643, 644, correspondants respectivement à la superposition :

- d'une deuxième cellule 62 non gravée, sur une première cellule 61 dans laquelle on a gravé une ouverture circulaire présentant un premier diamètre ;
- d'une deuxième cellule 62 dans laquelle on a gravé une ouverture circulaire présentant un deuxième diamètre, sur une première cellule 61 non gravée ;
- d'une deuxième cellule 62 dans laquelle on a gravé une ouverture circulaire présentant un deuxième diamètre, sur une première cellule 61 dans laquelle on a gravé une ouverture circulaire présentant un premier diamètre ; et
- d'une deuxième cellule 62 non gravée, sur une première cellule 61 non gravée.

En pratique, on pourra envisager des ouvertures non circulaires, par exemple ovales. On considère qu'une ouverture présente une forme circulaire ou ovale, sans prendre en compte les défauts de bords liés à la gravure par photolithographie. On pourra également envisager des formes opaques sur fond transparent. Chaque cellule pourra en outre être gravée selon des ouvertures de différentes dimensions, par exemple des disques de différents diamètres. On pourra varier les solutions d'une couche opaque à l'autre. Pour graver une ouverture dans une cellule à bords opaques, on peut réaliser des impacts lasers par déplacements du faisceau laser à partir du centre de la cellule. Pour graver une cellule de façon à obtenir une surface fermée opaque dans une cellule à bords transparents, on peut réaliser des impacts lasers par déplacements du faisceau laser sur les bords de la cellule.

Les quatre motifs élémentaires 641, 642, 643, 644 définissent quatre motifs de codage disponibles dans le cadre d'un tramage à modulation d'amplitude. Le niveau de gris d'un tel motif de codage correspond au coefficient de transmission moyen du motif élémentaire associé.

Dans le cadre d'un tramage à modulation d'amplitude, on code chaque pixel à l'aide du motif de codage dont le niveau de gris est le plus proche du niveau de gris dudit pixel.

On relèvera qu'on peut subdiviser un pixel de l'image source en plusieurs zones à associer à un motif de codage.

L'avantage du tramage à modulation d'amplitude relativement au tramage à modulation de fréquence est qu'il existe un lien direct entre un pixel de l'image source et le motif élémentaire associé.

Selon un mode de réalisation avantageux :

- les cellules d'une couche opaque sont gravées de façon à former, sur une cellule, une surface fermée transparente dans une cellule à bords opaques ; et
- les cellules d'une couche opaque située au-dessus sont gravées de façon à former, sur une cellule, une surface fermée opaque dans une cellule à bords transparents.

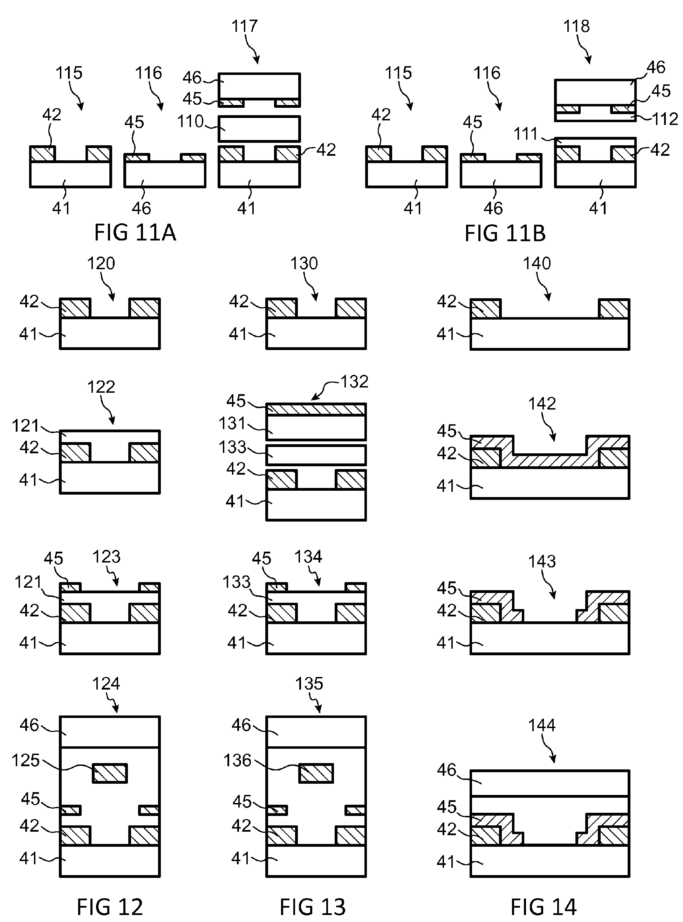

Ce mode de réalisation sera intitulé « mode de réalisation avec polarisations croisées des couches opaques ». On trouve un exemple d'un tel mode de réalisation illustré sur les figures 12 et 13.

La figure 7A illustre une étape de photolithographie sans masque d'une couche opaque épaisse 421. On voit que l'épaisseur de la couche opaque, associée à la forme conique du faisceau laser 21 focalisé, implique une taille minimale d'ouverture pouvant être gravée dans la couche opaque épaisse 421. Par exemple, pour une épaisseur de 100 nm de couche opaque en oxyde de platine, l'ouverture minimale est un disque de 4 $\mu$m de diamètre. En cas de photolithographie sans masque indirecte ou de photolithographie avec masque, le même phénomène est observé : si le composé chimique atteint la couche opaque en profondeur, il s'étale également latéralement.

La figure 7B illustre une étape de photolithographie sans masque d'une couche opaque mince 422. Comme précédemment, l'épaisseur de la couche opaque implique une taille minimale d'ouverture pouvant être gravée dans la couche opaque mince 422. Cette taille minimale est d'autant plus réduite que la couche est mince. Par exemple, pour une épaisseur de 25 nm de couche opaque en oxyde de platine, l'ouverture minimale est un disque de 0,6 $\mu$m de diamètre.

La figure 7C illustre un graphique représentant le diamètre minimum d'un disque pouvant être gravé dans une couche opaque d'oxyde de platine par photolithographie sans masque, en fonction de l'épaisseur de la couche opaque. L'axe des abscisses est gradué en nm. L'axe des ordonnées est gradué en $\mu$m. Cette figure illustre bien le fait que la taille minimale d'une ouverture pouvant être gravée dans la couche opaque est d'autant plus réduite que la couche est mince. On relèvera que cette taille minimale d'ouverture dépend également de la limite de diffraction de l'outil de gravure.

L'observation est la même dans le cas d'une gravure par photolithographie avec masque.

Comme précisé en référence à la figure 6B, on pourra envisager de graver dans une cellule une ouverture parmi plusieurs ouvertures prédéterminées. Les ouvertures prédéterminées sont les ouvertures pouvant être gravées par pas successifs d'agrandissement de l'ouverture, en partant de la taille minimale d'ouverture. Les pas successifs correspondent par exemple à des déplacements du faisceau laser sur la cellule, ou à des augmentations de l'intensité du faisceau laser fixe. Ainsi, plus l'épaisseur de la couche opaque est faible, plus une taille de cellule donnée offrira un nombre important d'ouvertures prédéterminées puisque l'on part alors d'une ouverture de très petite dimension. Cependant, plus l'épaisseur de la couche opaque est faible, plus le coefficient de transmission de cette couche sera important. Or, comme vu précédemment, lors de la lecture du support d'archivage, les teintes sombres codées dans le support d'archivage sont relatives à la couche opaque et les teintes claires sont relatives aux ouvertures gravées dans la couche opaque. De manière à optimiser la dynamique de détection, teinte sombre et teinte claire devront être les plus extrêmes possibles. Pour la teinte claire, la source d'éclairage sera alimentée de manière à générer un signal le plus proche possible de la limite haute de détection linéaire du détecteur matriciel. Pour la limite basse, la seule variable d'ajustement concerne le coefficient de transmission de la couche opaque. On voit donc que les deux critères de résolution de la gravure dans la couche opaque, et de dynamique de lecture du support d'archivage, impliquent deux conditions contraires sur l'épaisseur d'une couche opaque.

On relève que le même raisonnement s'applique dans le cas où l'on grave une cellule de façon à obtenir une surface opaque dans une cellule à bords transparents. La cellule est gravée en gravant tout autour de la surface opaque, et l'épaisseur de couche opaque est alors liée à une taille maximale de la surface opaque dans une cellule à bords transparents.

L'invention, en ce qu'elle propose la superposition d'au moins deux couches opaques, offre une manière astucieuse de concilier ces deux critères. A l'aide d'une première couche opaque mince, on peut graver des ouvertures de dimensions réduites. Grâce à la superposition d'au moins deux couches opaques, on peut atteindre des coefficients de transmission très faibles correspondant à l'empilement de couche, par exemple inférieurs à 5%. De préférence, on choisira des épaisseurs différentes pour chacune des couches opaques selon l'invention.

Les explications ci-dessus concernent plus particulièrement le cas d'un tramage à modulation d'amplitude, mais on retrouve également ces avantages dans le cadre d'un tramage à modulation de fréquence. D'après la figure 6A, chaque couche opaque est alors gravée en forme de damier, où chaque case du damier est soit entièrement gravée, soit non gravée. Ainsi, on voit qu'une faible épaisseur de la couche opaque permet de réaliser des cases de damier de dimensions réduites. La superposition de couches opaques évite cependant que cela entraîne une perte en dynamique de lecture.

Soient par exemple deux couches opaques. La première couche opaque présente une transmission $T_a$. La deuxième couche opaque présente une transmission $T_b$. Dans chaque cellule de la première couche opaque est gravé un disque de rayon $r_a$, centré sur la cellule. Dans chaque cellule de la deuxième couche opaque est gravé un disque de rayon $r_b$, centré sur la cellule. Chaque cellule est un carré de côté $\Lambda$. Pour chaque cellule, la superposition de la deuxième couche opaque sur la première couche opaque correspondra à un niveau de gris $\Gamma_{ab}$ (coefficient de transmission moyen d'une cellule où les deux couches $a$ et b sont empilées) :

$$\Gamma_{ab} = \left(T_a.T_b \times \Lambda^2 + T_a.(1-T_b)x\pi.r_b{}^2 + (1-T_a)x\pi.r_a{}^2\right)\frac{1}{\Lambda^2} \qquad (1)$$

Le niveau de gris correspond à des surfaces d'une cellule pondérées par des coefficients de transmission correspondant, le tout rapporté à la surface totale de la cellule.

On choisira par exemple :

- une première couche opaque d'oxyde de platine d'épaisseur 40 nm, de transmission environ 5%, et donnant un motif minimum de largeur environ égale à 800 nm ; et
- une deuxième couche opaque d'oxyde de platine d'épaisseur 30 nm, de transmission environ 10%, et donnant un motif minimum de largeur environ égale à 600 nm.

Le raisonnement est similaire dans cas d'une simple inscription par photolithographie d'une image sur un support.

On va maintenant décrire des étapes relatives à la réalisation d'une bibliothèque de motifs élémentaires, adaptée à une dynamique de tramage souhaitée. En d'autres termes, soit une image dans laquelle chaque pixel peut présenter un parmi 256 niveaux de gris différents, les niveaux de gris étant régulièrement espacés du blanc au noir, on souhaite avoir à sa disposition une bibliothèque de 256 motifs élémentaires, tels qu'on retrouve au mieux cet espacement régulier des niveaux de gris correspondant, allant du blanc jusqu'au noir.

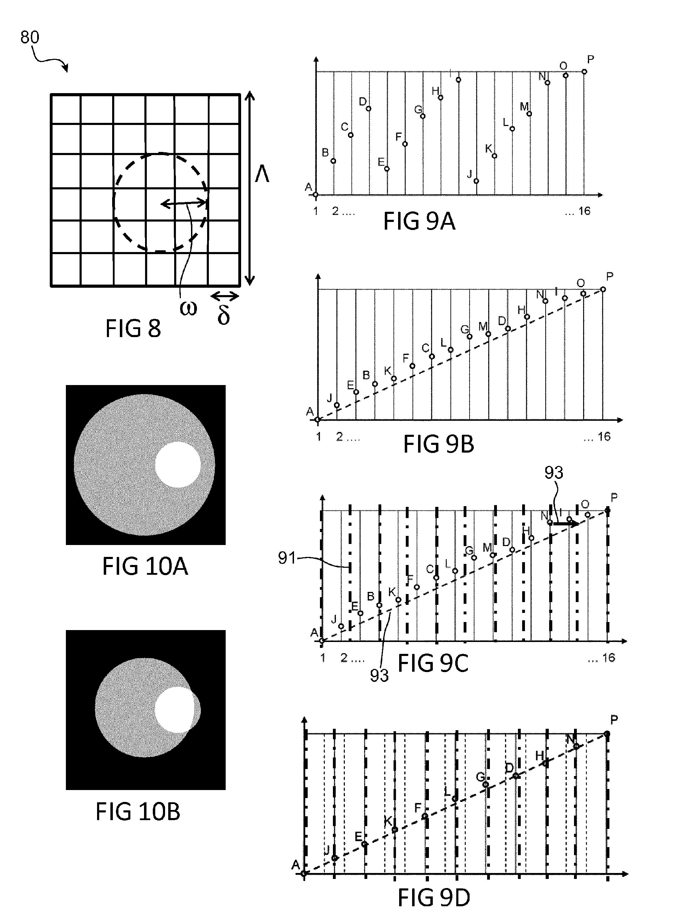

La figure 8 illustre une cellule 80 de la première couche opaque selon l'invention. La cellule est un carré de côté $\Lambda$. Sur cette cellule 80, on définit une grille d'adressage correspondant à une matrice de carrés de côté $\delta$. Cette grille correspond aux déplacements élémentaires d'un faisceau laser utilisé pour la gravure, relativement à la cellule 80. Dans cette cellule est gravé un disque de rayon minimal $\omega$.

On peut graver des ouvertures plus larges, à l'aide d'un ou plusieurs déplacement(s) élémentaire(s) du faisceau laser relativement à la cellule 80.

On obtient ainsi, pour une cellule donnée un ensemble E d'ouvertures possibles correspondant à un nombre $Nmsk$ de premiers motifs possibles :

$$Nmsk = \frac{\Lambda^2 - \pi.\omega^2}{\delta^2} \qquad (2)$$

Dans le cas d'une cellule de 2 $\mu$m de côté et d'un procédé donnant une ouverture minimale correspondant à un disque de diamètre 800 nm, une grille d'adressage de pas égal à 100 nm donnerait accès à un maximum de $Nmsk$ = 349 premiers motifs. Ces données sont indicatives. Dans la pratique, le nombre de premiers motifs disponibles est bien inférieur à la valeur donnée par l'équation (2), notamment car les dimensions de l'ouverture gravée ne peuvent pas être incrémentées rigoureusement à l'échelle du pas $\delta$ de la grille d'adressage, et les effets de bords sur la gravure réduisent d'autant plus la précision de réalisation.

Selon l'invention, on utilise :

- une première couche opaque *a,* donnant accès à un nombre $Nmsk_a$ de premiers motifs possibles ; et
- une deuxième couche opaque b, donnant accès à un nombre $Nmsk_b$ de deuxièmes motifs possibles.

Grâce à la superposition des deux couches opaques *a* et *b,* le nombre de motifs élémentaires disponibles est :

$$Nmsk_{ab} = Nmsk_a \times Nmsk_b \qquad (3)$$

Par exemple, $Nmsk_a$ = 349, pour les dimensions $\Lambda$, $\delta$ et $\omega$ précédemment citées. On a $Nmsk_b$ = 371, pour les mêmes dimensions $\Lambda$ et $\delta$, et pour une valeur de $\omega$ légèrement inférieure (épaisseur de la couche opaque b inférieure à celle de la couche opaque *a*). On a alors $Nmsk_{ab}$ = 129 4793. Même en tenant compte de la précision réelle de la gravure, les calculs montrent que la superposition de deux couches permet d'atteindre des niveaux de dynamique allant jusqu'à 16 bits.

On détaille ensuite comment, partant d'un nombre P de motifs élémentaires effectivement disponible (compte tenu des effets de bords de la gravure par exemple), on organise une bibliothèque de motifs élémentaires, adaptée à une dynamique de tramage souhaitée. Les motifs élémentaires effectivement disponibles dépendent, comme vu précédemment, de la dimension $\Lambda$ d'une cellule, du pas $\delta$ de la grille d'adressage, du rayon $\omega$ de l'ouverture minimale. Ils dépendent également de :

- la polarité du tramage (selon que l'ouverture dans une cellule d'une couche dessine une surface fermée transparente dans une cellule à bords opaques ou une surface fermée opaque dans une cellule à bords transparents) ;
- le procédé d'écriture (procédé physique de gravure, déterminant une différence entre une ouverture souhaitée et une ouverture effectivement obtenue, cette différence étant due notamment aux effets de bord) ;
- le type de tramage (forme de l'ouverture : ici une forme de disque, mais on pourrait envisager toute surface fermée).

Pour une ouverture en forme de disque, on a par exemple :

$$\Gamma = \begin{cases} 2 - p + (-1)^p \times \dfrac{\pi.\omega^2}{\Lambda^2} & si\ \omega \le \dfrac{\Lambda}{2} \\[3mm] 2 - p + (-1)^p \times \left( \dfrac{\pi.\omega^2}{\Lambda^2} - 4.S \right) & si\ \omega > \dfrac{\Lambda}{2} \end{cases} \qquad (4)$$

avec :

- $p$ l'indice de polarité ($p=2$ dans le cas d'un disque transparent dans une cellule à bords opaques, $p=1$ dans le cas d'un disque opaque dans une cellule à bords transparents),
- $S$ un facteur correctif tel que :

$$S = \frac{\omega^2}{\Lambda^2} \times \left\{ a\cos\left( \frac{\Lambda}{2.\omega} \right) - \frac{\Lambda}{2.\omega} \times \sin\left[ a\cos\left( \frac{\Lambda}{2.\omega} \right) \right] \right\},$$

et
- r le niveau de gris, ou coefficient de transmission moyen, d'une cellule d'une couche, en supposant un coefficient de transmission de 0 pour la couche opaque et de 1 pour l'ouverture.

La figure 9A illustre un diagramme dans lequel 16 motifs élémentaires disponibles A à P sont représentés, espacés régulièrement le long d'un axe des abscisses. L'axe des ordonnées correspond au coefficient de transmission moyen calculé ou mesuré correspondant à chaque motif élémentaire.

Sur la figure 9A, les motifs élémentaires sont classés dans leur ordre d'obtention : chaque premier motif disponible est combiné successivement avec tous les deuxièmes motifs disponibles.

Sur la figure 9B, les motifs élémentaires sont rangés par ordre croissant de coefficient de transmission moyen.

Sur la figure 9C, on a représenté les motifs de codage souhaités pour le codage d'une image. Les barres verticales 91 en trait mixte représentent chacune l'un des $X$ motifs de codage souhaités. La droite 92 en pointillés relie les deux extrémités souhaitées pour le codage. Ces extrémités correspondent respectivement à un motif élémentaire entièrement transparent et un motif élémentaire entièrement opaque. Les points A à P sont translatés horizontalement, de façon à les placer au plus près possible des points d'intersection entre la droite 92 et chacune des barres verticales 91. On voit par exemple que le point N, translaté horizontalement selon la flèche 93, vient se placer exactement sur l'un de ces points d'intersection. L'axe horizontal correspond à l'axe des abscisses des repères orthogonaux des figures 9A à 9D. Si le nombre de motifs élémentaires disponibles en figure 9B est supérieur à $X$, on supprime certains des points A à P (c'est le cas dans l'exemple représenté sur les figures 9A à 9D). Si le nombre de motifs élémentaires disponibles en figure 9B est inférieur à $X$, on duplique certains des points A à P. On obtient ainsi la bibliothèque de motifs élémentaires représentée sur la figure 9D.

Les figures 10A et 10B illustrent un défaut d'alignement d'un premier motif relativement à un deuxième motif. Dans le cas de la figure 10A, le défaut d'alignement ne modifie pas le niveau de gris du motif élémentaire de la cellule. Dans le cas de la figure 10B, le défaut d'alignement modifie le niveau de gris du motif élémentaire de la cellule. Pour chaque motif élémentaire, l'erreur sur le niveau de gris est prédictible, puisqu'on connait :

- le premier motif et le deuxième motif formant ensemble le motif élémentaire, et
- les capacités d'alignement d'une couche relativement à l'autre, fonction de la technique mise en oeuvre de superposition des deux couches.

Si l'erreur sur le niveau de gris d'un motif élémentaire dépasse un seuil d'erreur prédéterminé, ce motif élémentaire est retiré de la bibliothèque de motifs élémentaires représentée à la figure 9D. Il est remplacé par un autre motif élémentaire, choisi par exemple dans des motifs élémentaires supprimés lors du passage de la figure 9C à la figure 9D.

On pourra remarquer, comme illustré à la figure 10A, que la gravure correspondant à un tramage à modulation d'amplitude rend le procédé selon l'invention robuste à des erreurs d'alignement.

On peut relever que dans le cas d'un tramage à modulation de fréquence, la réalisation d'une bibliothèque de motifs élémentaires est inutile. Soit une image tramée par modulation de fréquence sur $2^n$ niveaux de gris, on réalise ces niveaux de gris à l'aide d'une superposition de n couches opaques.

On va maintenant décrire, en référence aux figures 11A à 14, différents modes de réalisation de procédés d'inscription selon l'invention. Sur les figures, pour des raisons de lisibilité, on a représenté dans une vue en coupe une unique cellule. Il s'agit plus particulièrement de procédés d'archivage.

Dans le premier mode de réalisation représenté à la figure 11A, le premier substrat transparent 41 est recouvert de la première couche opaque 42. La première couche opaque 42 est gravée par photolithographie (étape 115).

En parallèle ou séquentiellement, le deuxième substrat transparent 46 est recouvert de la deuxième couche opaque 45. La deuxième couche opaque 45 est gravée par photolithographie (étape 116).

Ensuite, l'ensemble formé du deuxième substrat transparent 46 et de la deuxième couche opaque 45 est déposé et collé sur la première couche opaque 42, de façon à ce que la deuxième couche opaque 45 se trouve entre la première couche opaque 42 et le deuxième substrat transparent 46.

Dans la variante représentée à la figure 11A, le collage est réalisé grâce à une couche de résine 110 déposée sur la première ou la deuxième couche opaque (étape 117).

Dans une autre variante de ce premier mode de réalisation, représentée à la figure 11B, le collage est réalisé par adhérence moléculaire. Pour cela, on dépose une couche de matériau transparent 111, 112 sur chacune des première et deuxième couches opaques 42, 45. Puis, on polit ces couches de matériau transparent 111, 112. Le matériau transparent est par exemple de l'oxyde d'aluminium $Al_2O_3$ ou de la silice $SiO_2$. Les couches de matériau transparent sont enfin déposées l'une sur l'autre, et restent reliées l'une à l'autre par adhérence moléculaire (étape 118).

On remarque que dans ce premier mode de réalisation, on retourne la deuxième couche opaque 45 pour la coller sur la première couche opaque. Il faut donc prévoir la gravure de la deuxième couche opaque 45 en conséquence.

Les dispositifs de collage actuellement disponibles offrent une précision d'alignement pour cette dernière étape de collage de l'ordre de $\pm 1\ \mu m$, ce qui permet d'utiliser une cellule carrée de côté $\Lambda$ égal à au moins $2\ \mu m$ (voir figure 8).

La figure 12 illustre un deuxième mode de réalisation de procédé d'inscription selon l'invention.

Selon ce deuxième mode de réalisation, le premier substrat transparent 41 est recouvert de la première couche opaque 42. La première couche opaque 42 est gravée par photolithographie (étape 120).

Ensuite, on dépose une couche de matériau transparent 121 sur la couche opaque précédemment gravée (étape 122). Ce matériau transparent est par exemple de la silice $SiO_2$. On obtient ainsi une surface plane du côté du matériau transparent opposé à la première couche de matériau opaque 42.

On dépose sur le matériau transparent 121 une nouvelle couche opaque 45. La nouvelle couche opaque 45 est gravée par photolithographie (étape 123).

Le procédé comprend ensuite une étape finale 124 de collage du deuxième substrat transparent 46 sur la couche opaque 125 précédemment gravée. Comme pour le premier mode de réalisation, cette dernière étape de collage peut être réalisée à l'aide d'une résine ou par adhérence moléculaire.

Les étapes 122 et 123 forment un cycle qui peut être répété autant de fois que souhaité. En d'autres termes, ce deuxième mode de réalisation du procédé selon l'invention présente au moins un cycle comprenant les étapes suivantes (la couche opaque précédemment gravée étant initialement la première couche opaque) :

- dépôt d'un matériau transparent sur la couche opaque précédemment gravée ;
- dépôt d'une nouvelle couche opaque sur le matériau transparent ;
- gravure, par photolithographie, de la nouvelle couche opaque formant alors la couche opaque précédemment gravée ;

Ce mode de réalisation présente l'avantage de permettre de superposer plus de deux couches opaques.

En outre, l'alignement des couches opaques les unes relativement aux autres est facilité par le fait que la gravure d'une couche opaque se fait après son dépôt sur la ou les couche(s) opaque(s) inférieure(s). En effet, la précision d'alignement de la gravure est meilleure que celle du collage. On atteint communément des précisions de 200 nm à l'aide d'équipements d'écriture laser du commerce.

L'alignement dépend également du coefficient de dilatation thermique $\alpha$ des substrats transparents, tel que :

$\Delta L = L.\alpha.\Delta T$, où L est une largeur du substrat, $\Delta T$ une variation de température au cours de la mise en oeuvre du procédé selon l'invention, et $\Delta L$ une variation de largeur du substrat induite par la variation de température $\Delta T$.

Par exemple, pour un support d'archivage de 200 mm de diamètre, la dilatation des substrats reste inférieure à $1\ \mu m$ à condition de stabiliser la température à 0,7 °C près pour du saphir, à 0,5°C près pour du verre, à 10°C près pour du quartz. Les salles blanches utilisant les équipements de lithographie et de collage sont stabilisées et contrôlées en température. Les platines de support des substrats garantissent des uniformités thermiques à +/- 0.5°C. On voit donc que ces variations de température autorisées sont en accord avec ce qui est techniquement faisable.

La figure 13 illustre un troisième mode de réalisation de procédé d'inscription selon l'invention, qui est une variante du procédé illustré en figure 12.

Le procédé illustré en figure 13 diffère du procédé illustré en figure 12 en ce que les étapes de dépôt d'un matériau transparent et dépôt d'une nouvelle couche opaque sont remplacées par une étape de collage sur la couche opaque précédemment gravée, d'un substrat transparent intermédiaire 131 (étape 132). Une nouvelle couche opaque 45 peut avoir été déposée sur le substrat transparent intermédiaire 131 avant le collage 132. En variante, on dépose une nouvelle couche opaque 45 sur le substrat transparent intermédiaire 131 après le collage 132.

Le collage est par exemple réalisé à l'aide d'une résine 133. En variante, il est réalisé par adhérence moléculaire. Le substrat transparent intermédiaire 131 est par exemple une feuille de verre d'épaisseur 30 $\mu$m à 100 $\mu$m.

La figure 14 illustre un quatrième mode de réalisation de procédé d'inscription selon l'invention.

Selon ce quatrième mode de réalisation, le premier substrat transparent 41 est recouvert de la première couche opaque 42. La première couche opaque 42 est gravée par photolithographie (étape 140).

Le procédé comprend ensuite une étape 142 de dépôt, directement sur la couche opaque précédemment gravée, d'une nouvelle couche opaque 45. La nouvelle couche opaque 45 est ensuite gravée par photolithographie (étape 143).

Le procédé comprend ensuite une étape finale 144 de collage du deuxième substrat transparent 46 sur la couche opaque précédemment gravée.

Les étapes 142 et 143 forment un cycle qui peut être répété autant de fois que souhaité. En d'autres termes, ce quatrième mode de réalisation du procédé selon l'invention présente au moins un cycle comprenant les étapes suivantes (la couche opaque précédemment gravée étant initialement la première couche opaque) :

- collage, sur la couche opaque précédemment gravée, d'une nouvelle couche opaque ;
- gravure, par photolithographie, de la nouvelle couche opaque, la nouvelle couche opaque formant alors la couche opaque précédemment gravée.

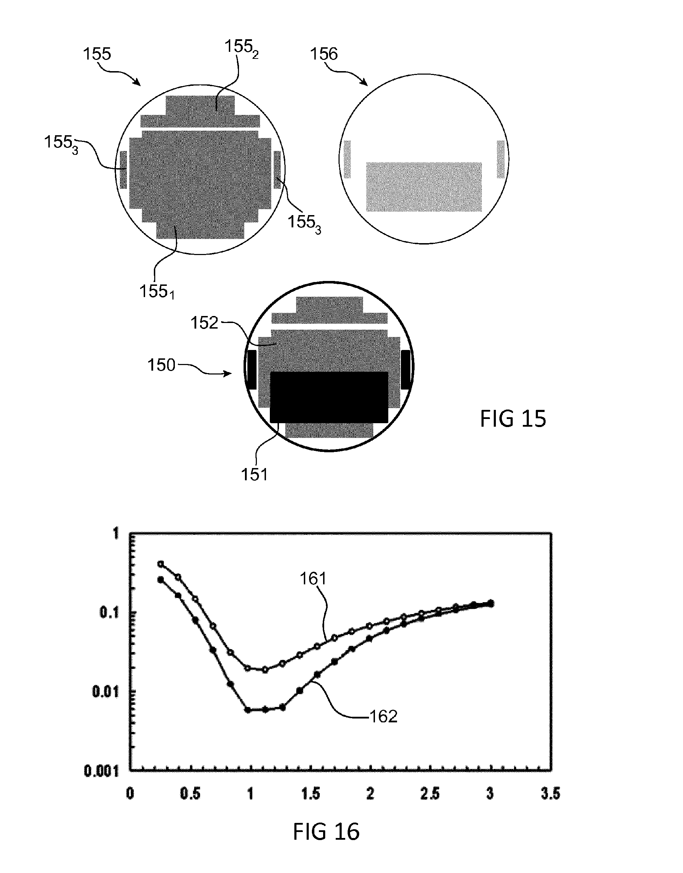

La figure 15 illustre un support d'archivage 150 selon l'invention, comprenant une zone d'archivage haute définition 151 (en noir) et une zone d'archivage basse définition 152 (en gris). En d'autres termes, la zone d'archivage haute définition ne correspond pas à l'étendue totale des données archivées dans le support d'archivage 150.

Pour simplifier la description, on parle d'une zone d'archivage haute définition 151 et d'une zone d'archivage basse définition 152, mais en réalité il y en a plusieurs : à une image source correspond une zone d'archivage basse ou haute définition et un même support reçoit plusieurs reproductions d'images sources.

On voit également à la figure 15 les deux parties 155, 156 du support d'archivage avant son assemblage (cas d'un procédé selon le premier mode de réalisation tel que décrit en référence aux figures 11A et 11B).

La partie 155 représente la partie principale du média, avec la couche opaque la plus épaisse. On y retrouve une zone de stockage des documents $155_1$, une zone de référencement $155_2$ (titre du média, table des matières, ...) et des zones de calibration et de mires d'alignement $155_3$.

La zone de référencement $155_2$ ne présente pas d'information haute définition, elle ne nécessite donc pas la mise en oeuvre du procédé selon l'invention. La zone de stockage des documents $155_1$ peut également comprendre des données basse définition pouvant être traitées par un procédé à couche opaque unique selon l'art antérieur. Ces zones, qui ne présentent pas d'informations haute définition, ne se retrouvent donc pas dans la seconde partie 156 du support d'archivage. Le traitement de la seconde partie 156 du support d'archivage peut ainsi être accéléré.

Dans le cas où une image en couleur doit être archivée, celle-ci est décomposée en trois composantes, chaque composante étant archivée indépendamment. On peut prévoir que certaines composantes soient archivées à l'aide d'une unique couche opaque, comme dans l'art antérieur, et que d'autres composantes soient archivées à l'aide d'au moins deux couches opaques superposées, par un procédé d'archivage selon l'invention.

Par exemple, une image est décomposée sur la base HSV ou LAB. La ou les composante(s) chromatique(s) détermine(nt) la dynamique de couleur de l'image. Ainsi, on choisira d'archiver la ou les composante(s) chromatique(s) par un procédé selon l'invention, dans la zone d'archivage haute définition 151 du support d'archivage. Les autres composantes sont archivées dans la zone d'archivage basse définition 152 du support d'archivage.

On décompose par exemple une image à archiver selon une décomposition LAB pour obtenir une composante intensité lumineuse, une première composante chromatique, et une deuxième composante chromatique. On archive les première et deuxième composantes chromatiques dans la zone d'archivage haute définition 151, et on archive la composante intensité lumineuse dans la zone d'archivage basse définition 152.

On peut également décomposer une image à archiver selon une décomposition HSV pour obtenir une composante « teinte », une composante « saturation », et une composante « intensité lumineuse ». On archive les composantes « teinte » et « saturation » dans la zone d'archivage haute définition 151, et on archive la composante « intensité lumineuse » dans la zone d'archivage basse définition 152.

On peut également privilégier une composante en prévoyant une reproduction réduite de cette composante de l'image, selon un facteur de réduction moindre.

La figure 16 illustre une comparaison de l'erreur quadratique moyenne entre une image source et sa représentation sous forme de motifs élémentaires, dans le cas d'un archivage selon l'art antérieur et dans le cas d'un archivage selon l'invention.

Plus précisément, on compare une image source et l'image obtenue après détection optique de sa représentation sous forme de motifs élémentaires. La détection optique est celle décrite en référence à la figure 3, utilisant une optique qui introduit un flou optique assimilable à une tache gaussienne de largeur *wg.* Il s'agit d'une détection optique par convolution gaussienne.

L'axe des abscisses correspond à la largeur wg de la gaussienne rapportée à la taille de la cellule.

L'axe des ordonnées correspond à l'erreur quadratique moyenne relativement à l'image source.

L'image source est une mire de tonalités de niveaux de gris constituée de 20x20 zones de tons gris différents aléatoirement distribués spatialement et dans la dynamique de 0 à 255. Les zones ont une étendue de 3x3 pixels, soit une image à coder de 60x60 pixels.

La courbe 161 correspond à un procédé d'archivage selon l'art antérieur mettant en oeuvre une unique couche d'oxyde de platine d'épaisseur 45 nm et un tramage à modulation d'amplitude mettant en oeuvre des ouvertures circulaires dans des cellules opaques. Le pas de la grille d'adressage est de $0,02\mu$m. On utilise une cellule carrée de côté $\Lambda$ égal à 2 $\mu$m (voir figure 8). L'erreur minimale est d'environ 2%.

La courbe 162 correspond à un procédé d'archivage selon l'invention mettant en oeuvre deux couches d'oxyde de platine d'épaisseurs 45 nm et 30 nm, et un tramage à modulation d'amplitude mettant en oeuvre des ouvertures circulaires dans des cellules opaques. Là-encore, le pas de la grille d'adressage est de $0,02\mu$m et on utilise une cellule carrée de côté $\Lambda$ égal à 2 $\mu$m. L'erreur minimale est d'environ 0,6%, soit environ 3 fois inférieure à l'erreur obtenue avec le procédé selon l'art antérieur et dans des conditions semblables.

Cette figure ne prend pas en compte la dynamique de détection, qui est également améliorée grâce au procédé selon l'invention.

L'invention n'est pas limitée aux modes de réalisation décrits. En particulier, on pourra prévoir toutes formes d'ouvertures gravées dans une couche opaque, d'autres épaisseurs de couche opaque, d'autres matériaux formant notamment les substrats transparents ou les couches opaques.

Pour certaines figures relatives à l'invention, on a représenté le cas d'une superposition de deux couches opaques. On pourra bien sûr étendre ces exemples au cas de la superposition de plus de deux couches opaques.

## Revendications

**1.** Procédé d'inscription d'une image source, dans lequel on réalise sous la forme d'une matrice de motifs élémentaires (631, 632, 633, 634; 641, 642, 643, 644), une reproduction de l'image source, ladite reproduction étant destinée à être lue en transparence, et le procédé comprenant les étapes suivantes :

- dépôt (401) sur un premier substrat (41) d'une première couche opaque (42) ;
- gravure (402) de la première couche opaque (42) sur toute son épaisseur, par photolithographie, de façon à former une matrice de premières cellules (440) présentant chacune un parmi plusieurs premiers motifs prédéterminés ;

**caractérisé par** :

- un dépôt d'au moins une deuxième couche opaque (45), de façon à ce que la deuxième couche opaque (45) se superpose à la première couche opaque (42) ; et
- une gravure de ladite deuxième couche opaque (45) sur toute son épaisseur, par photolithographie, de façon à former sur la deuxième couche opaque (45) une matrice de deuxièmes cellules (470) présentant chacune un parmi plusieurs deuxièmes motifs prédéterminés, lesdits motifs élémentaires étant chacun définis par la superposition d'un premier motif parmi lesdits premiers motifs prédéterminés et d'un second motif parmi lesdits deuxièmes motifs prédéterminés, et au moins un motif élémentaire étant défini par la superposition d'un premier motif sur un second motif différent dudit premier motif.

**2.** Procédé d'inscription selon la revendication 1, **caractérisé en ce qu'**il réalise un archivage d'une image source dans un support d'archivage comprenant un premier substrat transparent (41) et un second substrat transparent (41), et **en ce que** :

- le dépôt de la première couche opaque (42) est réalisé sur le premier substrat transparent (41) ;

- les étapes de gravure sont réalisées par photolithographie sans masque ; et
- le dépôt d'une deuxième couche opaque (45) est réalisé de façon à ce que la deuxième couche opaque (45) se trouve entre la première couche opaque (42) et le deuxième substrat transparent (46).

3. Procédé selon la revendication 1 ou 2, **caractérisé en ce que** les première et seconde couches opaques (42 ; 45 ; 421 ; 422 ; 125 ; 136) présentent des degrés d'opacité respectifs différents l'un de l'autre.

4. Procédé selon l'une quelconque des revendications 1 à 3, **caractérisé en ce que** les première et seconde couches opaques (42 ; 45 ; 421 ; 422 ; 125 ; 136) présentent des épaisseurs différentes et sont formées par un même matériau.

5. Procédé selon l'une quelconque des revendications 1 à 4, **caractérisé en ce que** :

   - chaque première cellule (61) et deuxième cellule (62) est soit intégralement gravée, soit non gravée, définissant ainsi par superposition une première série de motifs élémentaires (631, 632, 633, 634) disponibles pour réaliser la reproduction de l'image source ; et
   - on réalise un tramage à modulation de fréquence de l'image source, à l'aide de motifs de codage choisis parmi ladite première série de motifs élémentaires.

6. Procédé selon l'une quelconque des revendications 1 à 4, **caractérisé en ce que** :

   - chaque première cellule (61) et deuxième cellule (62) est gravée, ou non gravée, ou gravée de façon à former une surface fermée transparente dans une cellule à bords opaques ou une surface fermée opaque dans une cellule à bords transparents, définissant ainsi par superposition une seconde série de motifs élémentaires (641, 642, 643, 644) disponibles pour réaliser la reproduction de l'image source ; et
   - on réalise un tramage à modulation d'amplitude de l'image source, à l'aide de motifs de codage choisis parmi ladite seconde série de motifs élémentaires.

7. Procédé selon l'une quelconque des revendications 2 à 6, **caractérisé par** les étapes suivantes :

   - décomposition selon trois composantes d'une image à archiver;
   - inscription desdites trois composantes, chacune dans une zone d'archivage du support d'archivage (150) et entre le premier substrat transparent (41) et le deuxième substrat transparent (46), au moins une desdites composantes étant inscrite dans une zone d'archivage, dite zone d'archivage haute définition (151) à l'aide d'un procédé selon l'une quelconque des revendications 2 à 6, et au moins une desdites composantes étant inscrite dans une zone d'archivage, dite zone d'archivage basse définition (152), et en gravant, par photolithographie une unique couche opaque.

8. Procédé selon la revendication 7, **caractérisé en ce qu'**on décompose une image à archiver selon une décomposition HSV pour obtenir une composante « teinte », une composante « saturation », et une composante « intensité lumineuse », on inscrit les composantes « teinte » et « saturation » dans la zone d'archivage haute définition (151), et on inscrit la composante « intensité lumineuse » dans la zone d'archivage basse définition (152).

9. Procédé selon l'une quelconque des revendications 1 à 8, **caractérisé par** une étape de lecture en transparence de la reproduction d'une image source, comprenant les étapes suivantes :

   - éclairage de ladite reproduction à l'aide d'une source lumineuse (32) située d'un côté de ladite reproduction ;
   - détection d'une image de ladite reproduction, à l'aide d'un détecteur (34) situé du côté de ladite reproduction opposé à la source lumineuse.

10. Support d'image (50 ; 150) obtenu par la mise en oeuvre d'un procédé selon l'une quelconque des revendications 1 à 9, dans lequel est stockée, sous la forme d'une juxtaposition de motifs élémentaires, une reproduction d'une image source, ladite reproduction étant destinée à être lue en transparence, et ledit support d'image comprenant, sur un premier substrat (41), une première couche opaque (42) gravée sur toute son épaisseur par photolithographie et formant une matrice de premières cellules (440) présentant chacune un parmi plusieurs premiers motifs prédéterminés ; **caractérisé en ce que** :

   - le support d'image (50 ; 150) comprend au moins une deuxième couche opaque (45) gravée sur toute son épaisseur par photolithographie, formant une matrice de deuxièmes cellules (470), chaque deuxième cellule présentant un parmi plusieurs deuxièmes motifs prédéterminés ; et

- la deuxième couche opaque (45) est située sur la première couche opaque (42) de façon à définir lesdits motifs élémentaires (631, 632, 633, 634; 641, 642, 643, 644), formés par la superposition d'un premier motif et un deuxième motif, et au moins un motif élémentaire étant défini par la superposition d'un premier motif sur un second motif différent dudit premier motif.

11. Support d'image (50; 150) selon la revendication 10, **caractérisé en ce qu'**il forme un support d'archivage de l'image source et **en ce que** :

- il comprend au moins une zone d'archivage dite haute définition (51 ; 151) dans laquelle est stockée la reproduction de l'image source ;
- il comprend un premier substrat transparent (41) et un second substrat transparent (46), la première couche opaque étant située sur le premier substrat transparent (41) et la deuxième couche opaque (45) étant située entre la première couche opaque (42) et le deuxième substrat transparent (46).

12. Support d'image (50 ; 150) selon la revendication 10 ou 11, **caractérisé en ce que** la première couche opaque (42) et la deuxième couche opaque (45 ; 125 ; 136) présentent des épaisseurs différentes, chaque épaisseur étant comprise entre 10 nm et 200 nm.

13. Support d'image (50 ; 150) selon l'une quelconque des revendications 10 à 12, **caractérisé en ce que** chaque première cellule (61) et deuxième cellule (62) est soit intégralement gravée, soit non gravée.

14. Support d'image (50 ; 150) selon l'une quelconque des revendications 10 à 12, **caractérisé en ce que** chaque première cellule (61) et deuxième cellule (62) est intégralement gravée, ou non gravée, ou gravée de façon à former une surface fermée transparente dans une cellule à bords opaques ou une surface fermée opaque dans une cellule à bords transparents, des surfaces fermées formées dans différentes premières cellules présentant des dimensions différentes, des surfaces fermées formées dans différentes deuxièmes cellules présentant des dimensions différentes.

15. Support d'image (150) selon l'une quelconque des revendications 11 à 14, **caractérisé en ce qu'**il comprend :

- une première zone d'archivage haute définition (151), dans laquelle est stockée une reproduction d'une première image source correspondant à une première parmi trois composantes d'une image à archiver;
- une première zone d'archivage basse définition (152), dans laquelle est stockée une reproduction d'une deuxième image source correspondant à la deuxième composante de l'image à archiver, la zone d'archivage basse définition (152) comprenant, entre le premier substrat transparent (41) et le second substrat transparent (46), une unique couche opaque gravée par photolithographie ; et
- une deuxième zone d'archivage haute définition ou une deuxième zone d'archivage basse définition, dans laquelle est stockée une reproduction d'une troisième image source correspondant à la troisième composante de l'image à archiver.

FIG 1A

FIG 1B

FIG 1C

FIG 2A

FIG 2B

FIG 3

FIG 4

FIG 5A

FIG 5B

FIG 6A

631    632    633    634

FIG 6B

61    62

641    642    643    644

FIG 7A

FIG 7B

FIG 7C

80

FIG 8

FIG 9A

FIG 9B

FIG 10A

FIG 9C

93

91

93

FIG 10B

FIG 9D

FIG 11A

FIG 11B

FIG 12

FIG 13

FIG 14

FIG 15

FIG 16

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2105921 A